# EUROPEAN PATENT APPLICATION

(11) **EP 1 873 828 A2**
(43) Date of publication of application: **02.01.2008**
(21) Application number: 07012596.8
(22) Date of filing: 27.06.2007
(51) Int. Cl.: H01L 23/467

(54) **Heat sink for electronic component**

(30) Priority: 30.06.2006 JP 2006182004
(71) Applicant: Fanuc Ltd, Minamitsuru-gun, Yamanashi 401-0597 (JP)
(72) Inventor: Aoyama, Kazunari, Minamitsuru-gun, Yamanashi 401-0511 (JP); Nakamura, Minoru, Fujiyoshida-shi, Yamanashi 403-0005 (JP); Miura, Masahiro, Minamitsuru-gun Yamanashi 401-0511 (JP)
(74) Representative: Thum, Bernhard

(57) **Abstract**

A heat sink including a base and a plurality of upright heat-radiating projections provided on the base. The heat-radiating projections include a first projection having a first rigidity, and a second projection having at least a second rigidity partially lower than the first rigidity. The second projection is located along an outer periphery of an array or configuration of the plurality of heat-radiating projections on the base.

## Description

### BACKGROUND OF THE INVENTION

### 1. Field of the Invention

The present invention relates to a heat sink adapted to be attached to an electronic component for heat radiation.

### 2. Description of the Related Art

In electric or electronic equipment, it is known that a heat sink for heat radiation (i.e., a radiator) is attached directly or indirectly to a heatgenerative electronic component, such as a microprocessor and the like, in order to prevent malfunction or failure of the electronic component. Typically, the heat sink is formed from a metal block including a plurality of fin-shaped or pin-shaped upright projections provided on a plate-like base to increase the entire surface area thereof, and the heat of the electronic component is diffused through the heat sink due to air flowing between the projections. Also, it is known that an electrically driven fan is used to force air to flow between the projections in order to improve cooling capacity.

For example, Japanese Unexamined Patent Publication (Kokai) No. 8-31990 (JP-A-8-31990) discloses a configuration in which an electronic component (or a semiconductor chip) is mounted on a front surface of a circuit board while a heat sink having a heat-radiating fin is securely attached to a back surface of the circuit board. JP-A-8-31990 further discloses a configuration in which a heat sink having a heat-radiating fin is securely attached directly to the electronic component (or the semiconductor chip) mounted on the front surface of the circuit board.

In the conventional cooling structure for an electronic component using a heat sink, for example, in the configuration as set forth in JP-A-8-31990 in which the heat sink is securely attached directly to the electronic component mounted on the circuit board, stress may be concentrated on the electronic component, thereby damaging the electronic component, when unexpected external force is applied to the heat sink due to, for example, collision of the projections of the heat sink, extending largely outward from the surface of the circuit board, with surrounding objects. In this connection, damage to the electronic component due to external force applied to the heat sink tends to occur in a region of an electrically conductive connection to the circuit board, such as the lead, solder ball, etc., of the electronic component. On the other hand, the heat sink is typically formed from a metal block having rigidity sufficiently greater than that of the conductive connection region of the electronic component, and therefore, the result or evidence of a collision, etc., often does not remain in the heat sink itself. As a result, when the electric or electronic equipment is inspected or an investigation is made after a malfunction, a great deal of labor and time is needed in order to determine any damage to the conductive connection region of the electronic component (i.e., to determine that a malfunction is the result of external force applied to the heat sink).

### SUMMARY OF THE INVENTION

It is an object of the present invention to provide a heat sink adapted to be attached to an electronic component for heat radiation, which can prevent damage to the electronic component due to external force applied to the heat sink as much as possible, and which can easily determine the cause of the damage if the damage occurs.

To accomplish the above object, the present invention provides a heat sink comprising a base; and a plurality of heat-radiating projections provided on the base; the plurality of heat-radiating projections including a first projection having a first rigidity; and a second projection having at least a second rigidity partially lower than the first rigidity; the second projection being located along an outer periphery of an array or configuration of the plurality of heat-radiating projections on the base.

According to the above-described arrangement, a heat-radiating projection disposed at such a location as to be easily subjected to external force on the base is structured as the second projection having a relatively low rigidity, so that it is possible, when external force is applied to the heat sink, to relieve impact due to the external force by the deformation of the second projection, and thus to prevent stress from concentrating on, and the resultant damage of, an electronic component to which the heat sink is attached. Even under such circumstances, the first projection having a relatively high rigidity can maintain its own shape against external force, and therefore, the heat-radiating function of the heat sink is not significantly affected. Further, in the case where an electronic component to which the heat sink is attached is damaged when external force is applied to the heat sink in spite of the fact that the second projection is deformed, reliable evidence of the applied external force, such as the plastic deformation of the second projection, etc., remains, and therefore, it is possible to easily determine the cause of the damage and what portion is damaged.

In the above heat sink, the first projection may have a first cross-sectional area, and the second projection may have a second cross-sectional area smaller than the first cross-sectional area.

According to the above arrangement, it is possible to reliably ensure the most preferable effects by optimizing the shape, dimension and position of the second projection when the heat sink is designed.

Also, in the above heat sink, the second projection may include a proximal end portion made of a material identical to the material of the first projection and joined to the base, and a distal end portion made of a material different from the material of the proximal end portion and exhibiting the second rigidity.

According to the above arrangement, it is possible to provide the distal end portion, capable of exhibiting a sufficiently impact-relieving function, for the heat-radiating projection located at a position where it is highly anticipated that external force may be applied to the projection, among a plurality of heat-radiating projections, by a posterior attaching work as occasion demands, so as to structure the second projection.

### BRIEF DESCRIPTION OF THE DRAWINGS

The above and other objects, features and advantages of the present invention will become more apparent from the following description of preferred embodiments in connection with the accompanying drawings, wherein:
Fig. 1 is a perspective view showing a heat sink according to an embodiment of the present invention;
Fig. 2 is a cross-sectional view showing a main part of the heat sink of Fig. 1;
Fig. 3 is a perspective view showing the heat sink of Fig. 1, with a local deformation being caused by an external force;
Fig. 4 is a front view schematically showing one exemplary application of the heat sink of Fig. 1;
Fig. 5A is a front view showing a main part of a modification of a heat-radiating projection capable of being adopted in the heat sink of Fig. 1;
Fig. 5B is a plan view showing a main part of another modification of the heat-radiating projection;
Fig. 6A is a partially-sectional plan view showing a fin-shaped heat-radiating projection is a further modification;
Fig. 6B is a partially-sectional plan view showing a pin-shaped heat-radiating projection is a further modification; and
Fig. 7 is a perspective view showing a heat sink according to another embodiment of the present invention.

### DETAILED DESCRIPTION

The embodiments of the present invention are described below, in detail, with reference to the accompanying drawings. In the drawings, the same or similar components are denoted by common reference numerals.

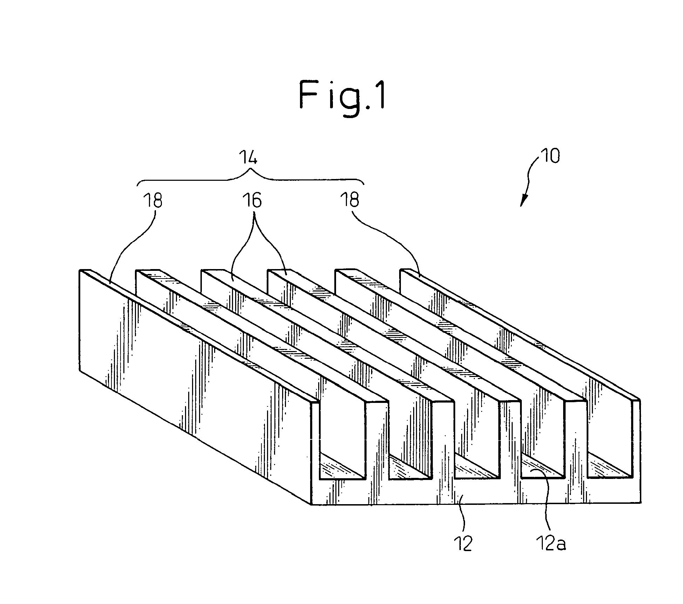

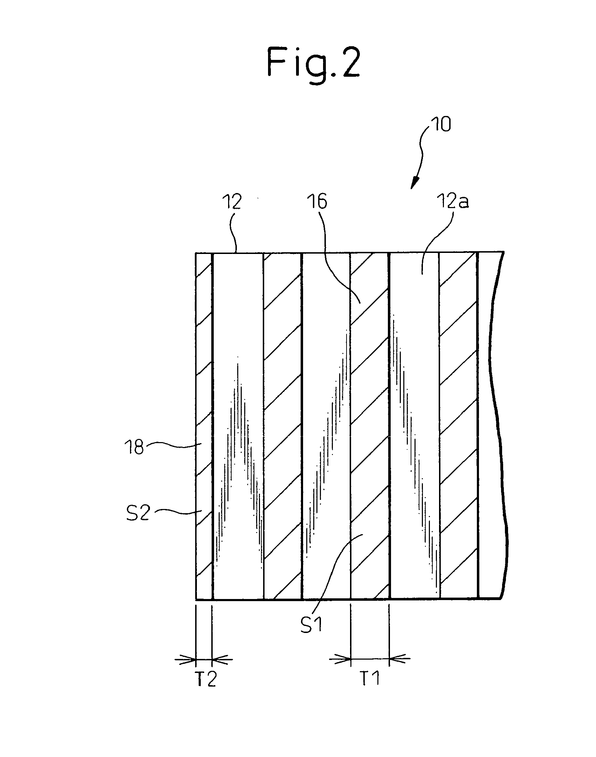

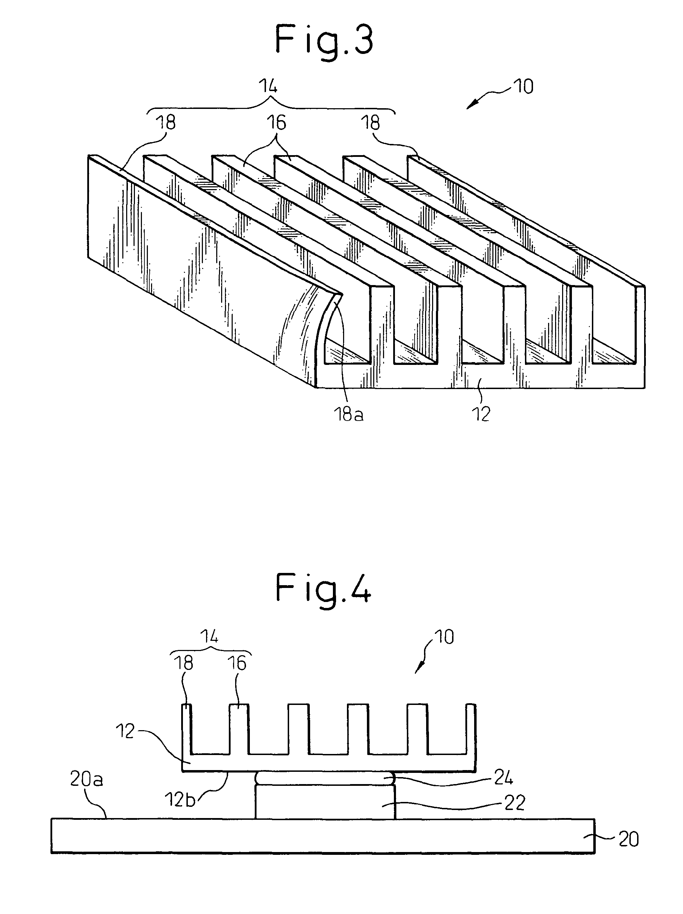

Referring to the drawings, Fig. 1 is a perspective view of a heat sink 10 according to an embodiment of the present invention, Fig. 2 is a cross-sectional view of the heat sink 10, Fig. 3 is a perspective view of the heat sink 10 in which a local deformation is caused by an external force, and Fig. 4 is a front view schematically showing one exemplary application of the heat sink 10.

As shown in Fig. 1, the heat sink 10 includes a base 12, and a plurality of upright heat-radiating projections 14 provided on the base 12. The heat-radiating projections 14 include a first projection 16 and a second projection 18, which have rigidities, different from each other, for maintaining their shape against external force. The second projections 18, having a rigidity lower than the rigidity of the first projections 16, is located along an outer periphery of an array or configuration of the plurality of heat-radiating projections 14 on the base 12.

The base 12 is a rectangular flat-plate element, and is provided on one flat surface 12a thereof with the plurality of heat-radiating projections 14, each of which is a fin-shaped (or thin plate-like) element, and which project in an integral or unitary manner from the base 12 and are generally arranged parallel with each other at regular intervals. In the illustrated embodiment, a plurality of (four, in the drawing) first projections 16, each having a rigidity higher than the rigidity of the second projection 18, are arranged near a center of the surface 12a of the base 12 and a plurality of (two, in the drawing) second projections 18, each having the rigidity lower than the rigidity of the first projections 16, are arranged along a pair of outer edges of the base surface 12a. The heat sink 10 is integrally or unitarily molded, in its entirety, from a metallic material having excellent heat conductivity.

As shown in Fig. 2, each first projection 16 with a relatively high rigidity has a first cross-sectional area S1 (or a first thickness T1) in a sectional plane generally parallel with the base surface 12a, and each second projection 18 with a relatively low rigidity has a second cross-sectional area S2 (or a second thickness T2) smaller than the first cross-sectional area S1 in a sectional plane generally parallel with the base surface 12a. According to this configuration, as shown in, e.g., Fig. 3, as soon as an external force in a certain force range is applied to the respective heat-radiating projections 14, the first projections 16 may keep their own shape while the second projections 18 are deformed. Fig. 3 shows, by way of example, a situation in which one of the second projections 18 has plastic deformation at a corner 18a of its extremity.

As shown by way of example in Fig. 4, the heat sink 10 is securely attached, on a back surface 12b of the base 12 thereof, to an electronic component (e.g., a microprocessor) 22 mounted on a surface 20a of a circuit board 20, directly through an adhesive layer 24 having excellent heat conductivity. In this state, due to air flowing between the plurality of heat-radiating projections 14 (i.e., the first projections 16 and the second projections 18) of the heat sink 10, heat generated during operation of the electronic component 22 diffuses through the heat sink 10. In this connection, the heat sink 10 may be additionally provided with an electrically driven fan (not shown) for forcing air to flow between the heat-radiating projections 14 in order to improve cooling capacity.

In the configuration wherein the heat sink 10 is securely attached directly to the electronic component 22 mounted on the circuit board 20 in a manner as described above, stress may concentrate on the electronic component 22, thereby damaging the electronic component 22 (particularly, in a region for electrically conductive connection to the circuit board 20, such as a lead, a solder ball, etc.), when unexpected external force is applied to the heat sink 10 due to, for example, the collision of the heat-radiating projections 14 of the heat sink 10, extending significantly outward from the surface 20a of the circuit board 20, with surrounding objects. Therefore, in the heat sink 10, among the plurality of heat-radiating projections 14, the second projection 18, located along the outer periphery of the array or configuration of the heat-radiating projections 14 on the base 12, is structured to have lower rigidity allowing the second projections 18 to be deformed by less external force, compared with the first projection 16.

Among the plurality of heat-radiating projections 14 of the heat sink 10, the heat-radiating projection 14 located along the outer periphery of the array or configuration of the heat-radiating projections 14 on the base 12 is, in particular, likely to receive unexpected external force, due to a collision with surrounding objects caused by, e.g., carelessness in manufacturing, transportation, storage, parts replacement, etc., of electric or electronic equipment. In the heat sink 10 in which the heat-radiating projection 14, disposed at such a location as to be easily subjected to external force, is structured as the second projection 18 having relatively low rigidity, it is possible, when external force is applied, to relieve the impact due to the external force by the deformation of the second projection 18, and thus to effectively prevent stress from concentrating on, and the resultant damage of, the electronic component 22. It should be noted that, even under the above circumstances, the first projections 16 having relatively high rigidity can maintain their shape against external force, and therefore, the heat-radiating function of the heat sink 10 is not significantly affected.

Further, in the case where the second projection 18 is deformed, but the electronic component 22 is damaged when external force is applied to the heat sink 10, reliable evidence of the applied external force, such as the plastic deformation of the second projection 18, etc., remains, and therefore, when the electric or electronic equipment is inspected or an investigation is made after a malfunction, it is possible to easily determine that the malfunction is the result of external force applied to the heat sink 10 and the conductive connection region of the electronic component 22 may thereby be damaged. As described above, according to the heat sink 10, it is possible to prevent damage to the electronic component 22 due to external force applied to the heat sink 10 as much as possible, and thus easily determine the cause of damage if damage occurs.

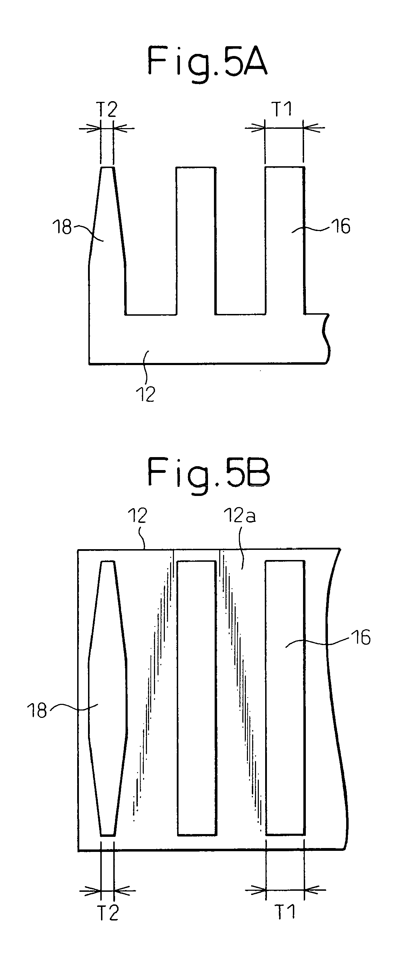

In the present invention, among the plurality of the heat-radiating projections 14 provided on the heat sink 10, the first projection 16 and the second projection 18, having rigidities different from each other in order to maintain their shape against external force, are not limited to the configuration of the above-described embodiment, and other various configurations may be adopted. For example, as shown in Figs. 5A and 5B, in place of the above-described configuration wherein the thickness T2 of each second projection 18 is entirely and uniformly smaller than the thickness T1 of each first projection 16, the thickness of the second projection 18 may be gradually reduced toward its top end farthest from the base 12 (Fig. 5A), or may be gradually reduced toward opposite longitudinal ends along the base surface 12a (Fig. 5B).

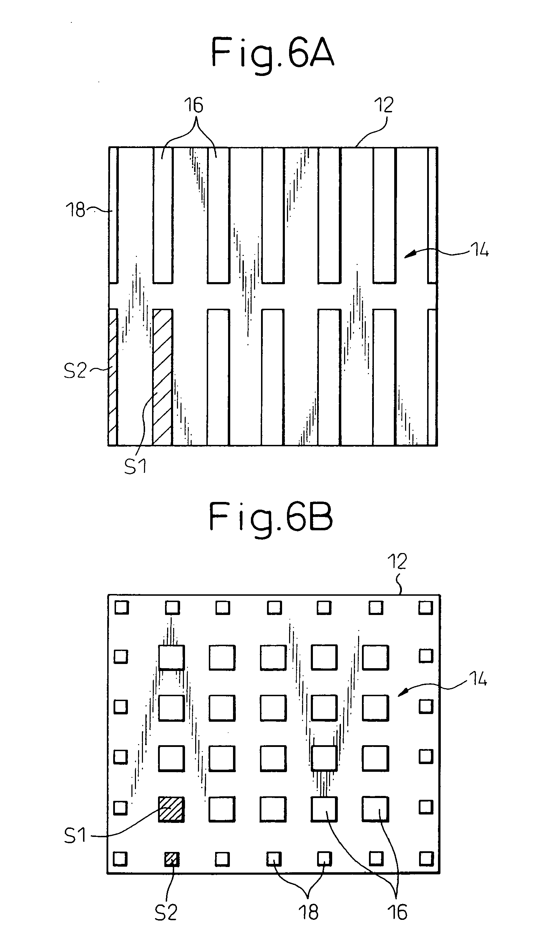

Also, as shown in Figs. 6A and 6B, in a configuration having fin-shaped heat-radiating projections 14 arranged in a plurality of separate rows (Fig. 6A), or in a configuration having a large number of pin-shaped heat-radiating projections 14 (Fig. 6B), it is possible ensure operative effects equivalent to those of the above-described embodiment by disposing the second projections 18 each having the rigidity lower than the rigidity of the first projection 16 (i.e., the second projections 18 each having the second cross-sectional area S2 smaller than the first cross-sectional area S1 of the first projection 16) along the outer periphery of the array or configuration of the plurality of heat-radiating projections 14 on the base 12. In any case, it is possible to reliably ensure the most preferable effect by optimizing the shape, dimension and position of the second projection 18 when the heat sink 10 is designed.

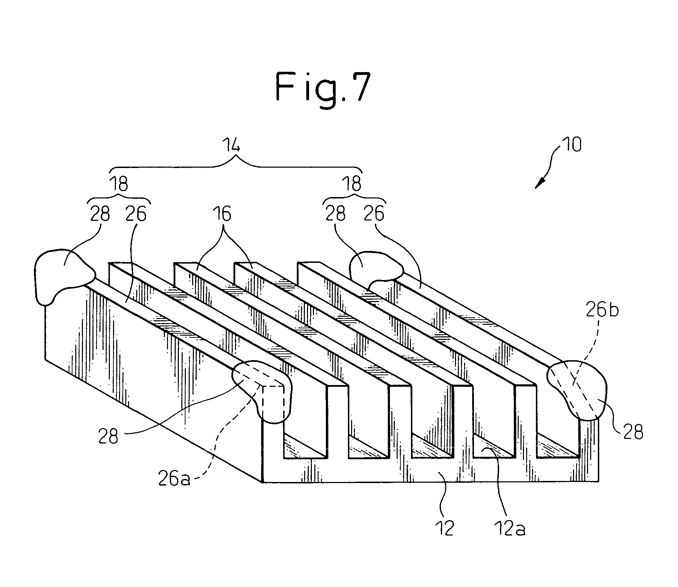

Moreover, as shown in Fig. 7 as another embodiment of the present invention, in place of the above-described configuration wherein the cross-sectional area S2 of the second projection 18 is smaller than the cross-sectional area S1 of the first projection 16, another configuration may also be adopted, wherein the second projection 18 includes a proximal end portion 26 made of a material identical to the material of the first projection 16 and joined to the base 12, and distal end portion 28 made of a material different from the material of the proximal end portion 26 and exhibiting rigidity lower than the rigidity of the first projection 16.

In the second embodiment described above, among a plurality of heat-radiating projections 14, all of which have an identical shape and dimension, the heat-radiating projection 14 located along the outer periphery of the array or configuration of the heat-radiating projections 14 on the base 12 may be structured as the second projection 18. In this configuration, the second projection 18 is provided with the proximal end portion 26 having a shape and dimension identical to that of each of the remaining first projections 16, and is structured by securely attaching the distal end portion 28 made of, e.g., silicone rubber, urethane rubber, soft resin, to a corner 26a of the extremity of the proximal end portion 26. Alternatively, the heat-radiating projection 14 located along the outer periphery of the array or configuration of the heat-radiating projections 14 on the base 12 may be structured in advance as the second projection 18, by molding the proximal end portion 26 having a shape different from that of the first projection 16 (for example, a shape having a chamfered portion 26b at the corner of its extremity) in a manner as to be integral or unitary with the base 12, and securely attaching the distal end portion 28 to the proximal end portion 26, so as to obtain a shape similar to that of the first projection 16.

In the heat sink 10 according to the above-described second embodiment, in which the heat-radiating projection 14, disposed at such a location as to be easily subjected to unexpected external force, is structured as the second projection 18 including the distal end portion 28 having relatively low rigidity, it is possible, when external force is applied, to relieve impact due to external force by the deformation of the distal end portion 28 of the second projection 18, and thus to effectively prevent stress from concentrating on, and the resultant damage of, the electronic component 22. Further, in the case where the material of the distal end portion 28 is selected so that the distal end portion 28 has plastic deformation by external force, reliable evidence of the applied external force remains, and therefore, when the electric or electronic equipment is inspected or an investigation is made after a malfunction, it is possible to easily determine the cause of malfunction and the damaged portion. In particular, according to the second embodiment, among the plurality of heat-radiating projections 14, it is possible to provide the distal end portion 28, capable of exhibiting a sufficiently impact-relieving function, for the heat-radiating projection 14 located at a position where it is highly anticipated that external force may be applied to the projection, by a posterior attaching work as occasion demands, and therefore, there is an advantage that the heat sink 10 can be made more versatile.

In the above-described second embodiment, in order not to impair the heat-radiating function of the heat sink 10, it is advantageous that the distal end portion 28 of the second projection 18 is made of a material that is not only adapted to be deformed (preferably, plastically deformed) relatively easily by external force, but also has excellent heat-resistance and heat-radiating properties. Further, the configuration of the second projection 18 structured by two types of elements may be additionally applied to the second projection 18 having a cross-sectional area smaller than that of the first projection 16 as already described.

While the invention has been described with reference to specific preferred embodiments, it will be understood, by those skilled in the art, that various changes and modifications may be made thereto without departing from the scope of the following claims.

## Claims

1. A heat sink (10) comprising a base (12) and a plurality of heat-radiating projections (14) provided on said base, **characterized in that**:
said plurality of heat-radiating projections includes:
a first projection (16) having a first rigidity; and
a second projection (18) having at least a second rigidity partially lower than said first rigidity;
said second projection being located along an outer periphery of an array of said plurality of heat-radiating projections on said base.

2. A heat sink as set forth in claim 1, wherein said first projection has a first cross-sectional area, and said second projection has a second cross-sectional area smaller than said first cross-sectional area.

3. A heat sink as set forth in claim 1 or 2, wherein said second projection includes a proximal end portion (26) made of a material identical to a material of said first projection and joined to said base, and a distal end portion (28) made of a material different from the material of said proximal end portion and exhibiting said second rigidity.
